# EUROPÄISCHE PATENTSCHRIFT

(11) **EP 2 460 190 B1**
(45) Veröffentlichungstag und Bekanntmachung des Hinweises auf die Patenterteilung: **15.03.2017**
(21) Anmeldenummer: 10732957.5
(22) Anmeldetag: 13.07.2010
(51) Int. Cl.: H01L 33/20, H01L 33/40, H01L 33/00, H01L 33/44

(54) **LEUCHTDIODENCHIP**
LIGHT-EMITTING DIODE CHIP
PUCE DE DIODE ÉLECTROLUMINESCENTE

(30) Priorität: 31.07.2009 DE 102009035429
(43) Veröffentlichungstag der Anmeldung: 06.06.2012
(73) Patentinhaber: OSRAM Opto Semiconductors GmbH, 93055 Regensburg (DE)
(72) Erfinder: MAUTE, Markus, 93087 Alteglofsheim (DE); ALBRECHT, Tony, 93077 Bad Abbach (DE); KASPRZAK-ZABLOCKA, Anna, 93093 Donaustauf (DE)
(74) Vertreter: Epping - Hermann - Fischer
(86) Internationale Anmeldenummer: PCT/EP2010/060077
(87) Internationale Veröffentlichungsnummer: WO 2011/012446

(56) Entgegenhaltungen:
- DE-A1- 4 427 840
- US-A- 5 753 940
- US-A1- 2004 046 180
- US-A1- 2008 197 367

## Beschreibung

Es werden ein Leuchtdiodenchip sowie ein Verfahren zur Herstellung eines Leuchtdiodenchips angegeben.

Diese Patentanmeldung beansprucht die Priorität der deutschen Patentanmeldung 10 2009 035 429.8.

Eine zu lösende Aufgabe besteht darin, einen Leuchtdiodenchip anzugeben, der vor äußeren mechanischen Beschädigungen geschützt ist und eine erhöhte Lebensdauer aufweist.

Diese Aufgabe wird durch die Ausführungsformen gemäß den anhängigen Ansprüchen gelöst.

Gemäß zumindest einer Ausführungsform umfasst der Leuchtdiodenchip einen Halbleiterkörper, der einen ersten und einen zweiten Bereich aufweist. Beispielsweise ist der Halbleiterkörper mit einer epitaktisch gewachsenen Halbleiterschichtenfolge gebildet. Zum Beispiel ist der Halbleiterkörper vollständig durch den ersten und den zweiten Bereich gebildet, wobei dann der erste und der zweite Bereich ebenso mit der epitaktisch gewachsenen Halbleiterschichtenfolge gebildet sind. "Bereich" bedeutet in diesem Zusammenhang, eine dreidimensionale Teilstruktur des Halbleiterkörpers, welche den Halbleiterkörper stellenweise ausbildet und ausformt.

Gemäß zumindest einer Ausführungsform umfasst der Leuchtdiodenchip eine aktive Zone innerhalb des Halbleiterkörpers. Bei der aktiven Zone kann es sich um eine Schicht handeln, die im Betrieb des Leuchtdiodenchips elektromagnetische Strahlung in einem Wellenlängenbereich innerhalb des ultravioletten bis infraroten Spektralbereichs der elektromagnetischen Strahlung emittiert.

Gemäß zumindest einer Ausführungsform emittiert die aktive Zone im Betrieb des Leuchtdiodenchips elektromagnetische Strahlung durch eine Strahlungsauskoppelfläche, die zumindest stellenweise durch eine erste Hauptfläche des Halbleiterkörpers gebildet ist. Die erste Hauptfläche des Halbleiterkörpers ist dabei ein Teil der Außenfläche des Halbleiterkörpers. Die erste Hauptfläche verläuft zum Beispiel senkrecht zur Wachstumsrichtung des epitaktisch hergestellten Halbleiterköpers. Durch die Strahlungsauskoppelfläche wird die in der aktiven Zone innerhalb des Halbleiterkörpers erzeugte elektromagnetische Strahlung zumindest zum Teil aus dem Halbleiterkörper ausgekoppelt.

Gemäß zumindest einer Ausführungsform umfasst der Leuchtdiodenchip zumindest einen Graben in dem Halbleiterkörper, wobei im Bereich des Grabens Teile des Halbleiterkörpers entfernt sind. Das heißt, dass zumindest stellenweise der Graben seitlich durch den Halbleiterkörper begrenzt ist. Der zumindest eine Graben weist eine einer Öffnung des Grabens gegenüberliegende Bodenfläche sowie zwei Seitenflächen auf, welche durch die Bodenfläche miteinander verbunden sind. Der Graben ist zum Beispiel durch Materialabtrag erzeugt. Es handelt sich bei dem Graben also um eine Ausnehmung im Halbleiterkörper.

Ebenso ist denkbar, dass der zumindest eine Graben die aktive Zone durchbricht. An Stellen, an denen der zumindest eine Graben verläuft, wird dann die aktive Zone "unterteilt". Weist der Halbleiterkörper mehrere übereinander gestapelte aktive Zonen auf, so durchbricht der zumindest eine Graben wenigstens alle aktiven Zonen.

Gemäß zumindest einer Ausführungsform umgibt der zumindest eine Graben den ersten Bereich in lateraler Richtung. "Lateral" bezeichnet die Richtungen parallel zur epitaktisch gewachsenen Halbleiterschichtenfolge des Halbleiterkörpers. D.h. der Graben umschließt den ersten Bereich vollständig und umschließt in einer Draufsicht ein kreisförmiges, rechteckiges oder andersartig ausgebildetes Gebiet. Erster und zweiter Bereich sind dann von dem zumindest einen Graben getrennt, sodass der Halbleiterkörper durch den Graben in den ersten und in den zweiten Bereich unterteilt ist.

Gemäß zumindest einer Ausführungsform umgibt der zweite Bereich den zumindest einen Graben und den ersten Bereich in lateraler Richtung vollständig. Der zweite Bereich bildet dann eine randseitige, dreidimensionale Teilstruktur des Halbleiterkörpers, welche sowohl den zumindest einen Graben als auch den ersten Bereich beispielsweise kreisförmig, rechteckig oder andersartig vollständig umschließt.

Gemäß zumindest einer Ausführungsform umfasst der Leuchtdiodenchip einen Halbleiterkörper, der einen ersten und einen zweiten Bereich aufweist. Ferner umfasst der Halbleiterkörper eine aktive Zone innerhalb des Halbleiterkörpers, die im Betrieb des Leuchtdiodenchips elektromagnetische Strahlung durch eine Strahlungsauskoppelfläche emittiert, die zumindest stellenweise durch eine erste Hauptfläche des Halbleiterkörpers gebildet ist. Ferner umfasst der Leuchtdiodenchip zumindest einen Graben in dem Halbleiterkörper, wobei im Bereich des Grabens Teile des Halbleiterkörpers entfernt sind. Der zumindest eine Graben umgibt den ersten Bereich in lateraler Richtung vollständig. Ferner umgibt der zweite Bereich den zumindest einen Graben und den ersten Bereich in lateraler Richtung vollständig.

Der hier beschriebene Leuchtdiodenchip beruht dabei unter anderem auf der Erkenntnis, dass Beschädigungen von Leuchtdiodenchips insbesondere in deren randseitigem Bereich zu erheblichen und schwer zu kontrollierenden Qualitätsproblemen führen. Beispielsweise treten diese Beschädigungen bei einer Weiterbearbeitung der Leuchtdiodenchips oder während eines Vereinzelungsprozesses in einzelne Leuchtdiodenchips auf.

Um nun einen Leuchtdiodenchip zu schaffen, der in einem strahlungsemittierenden Bereich keine mechanischen Beschädigungen aufweist, macht der hier beschriebene Leuchtdiodenchip unter anderem von der Idee Gebrauch, zumindest einen Graben in einen Halbleiterkörper des Leuchtdiodenchips einzubringen, wobei der zumindest eine Graben einen ersten Bereich in lateraler Richtung vollständig umgibt. Beispielsweise ist der erste Bereich dann der primär strahlungsemittierende Bereich des Halbleiterkörpers und damit auch des Leuchtdiodenchips. Ferner umgibt ein zweiter Bereich den zumindest einen Graben und den ersten Bereich in lateraler Richtung. Sowohl der zweite Bereich als auch der Graben können dann einen randseitigen "Schutzbereich" bilden, der den ersten Bereich beispielsweise bei einem Vereinzelungsprozess vor mechanischen Beschädigungen schützt. Dazu erfolgt eine Vereinzelung außerhalb des ersten Bereichs und des zumindest einen Grabens. Ferner bietet der in den Halbleiterkörper eingebrachte zumindest eine Graben die Möglichkeit, die Außenfläche des Halbleiterkörpers im Bereich der aktiven Zone visuell auf Schäden zu kontrollieren.

Ein solcher Leuchtdiodenchip ist z.B. in dem Dokument US2008/0197367 A1 beschrieben.

Gemäß der erfindungsgemäßen Ausführungsform ist eine der ersten Hauptfläche des Leuchtdiodenchips gegenüberliegende Fläche des Halbleiterkörpers mit einer Reflektorschicht versehen. Die von der aktiven Zone innerhalb des Halbleiterkörpers emittierte elektromagnetische Strahlung wird von der Reflektorschicht in Richtung der Strahlungsauskoppelfläche zurück reflektiert und durch die Strahlungsauskoppelfläche aus dem Leuchtdiodenchip ausgekoppelt. Die die Fläche ist sowohl im ersten als auch im zweiten Bereich des Halbleiterkörpers mit der Reflektorschicht versehen. Vorteilhaft wird dadurch sowohl die von der aktiven Zone im ersten als auch im zweiten Bereich erzeugte elektromagnetische Strahlung durch die Reflektorschicht in Richtung der Strahlungsauskoppelfläche reflektiert und dann aus dem Leuchtdiodenchip ausgekoppelt. Eine solche sich über die gesamte laterale Ausdehnung des ersten und des zweiten Bereichs erstreckende Reflektorschicht erhöht somit die Auskoppeleffizienz des Leuchtdiodenchips. "Auskoppeleffizienz" ist das Verhältnis von tatsächlich aus dem Leuchtdiodenchip ausgekoppelte Leuchtenergie zu der primär innerhalb des Leuchtdiodenchips erzeugten Leuchtenergie.

Gemäß der erfindungsgemäßen Ausführungsform umfasst der Leuchtdiodenchip ein Trägerelement und die Reflektorschicht ist zwischen dem Trägerelement und dem Halbleiterkörper angeordnet, wobei der Halbleiterkörper mittels eines Verbindungsmaterials am Trägerelement befestigt ist. Vorzugsweise verbindet das Verbindungsmaterial dann den Halbleiterkörper und das Trägerelement mechanisch miteinander. Bei dem Verbindungsmaterial kann es sich beispielsweise um ein Lot handeln. Beispielsweise ist dann das Lot mit einem bleifreien oder bleihaltigen Lötzinn gebildet. Ebenso ist es möglich, dass das Verbindungsmaterial mit einem Klebstoff gebildet ist. Beispielsweise handelt es sich bei dem Klebstoff um einen Silberleitklebstoff. Bei dem Trägerelement handelt es sich also nicht um ein Aufwachssubstrat des Halbleiterkörpers. Vielmehr kann ein Aufwachssubstrat vom Halbleiterkörper entfernt sein.

Gemäß der erfindungsgemäßen Ausführungsform ist das Verbindungsmaterial an seiner dem Trägerelement abgewandten Seite vollständig vom Halbleiterkörper und/oder einer Passivierungsschicht bedeckt. Bei der Passivierungsschicht handelt es sich um eine Grenzschicht, die direkt beispielsweise auf die erste Hauptfläche des Halbleiterkörpers aufgebracht ist. Vorteilhaft verhindert die Passivierungsschicht an den Stellen, auf denen sie aufgebracht ist, eine Oxidation des Halbleitermaterials. In diesem Zusammenhang ist zwar die Seitenflächen des zumindest einen Grabens durch den Halbleiterkörper gebildet sind, jedoch ist die Bodenfläche des Grabens durch das Verbindungsmaterial gebildet. An den freiliegenden Stellen ist dann die Passivierungsschicht direkt auf das Verbindungsmaterial aufgebracht.

Gemäß zumindest einer Ausführungsform verjüngt sich der erste Bereich des Halbleiterkörpers in einer Richtung ausgehend vom Trägerelement hin zu der ersten Hauptfläche des Halbleiterkörpers. Das heißt, dass der erste Bereich des Halbleiterkörpers seitlich jeweils durch mindestens eine Seitenfläche des zumindest einen Grabens begrenzt ist und dadurch der erste Bereich sich in einer Richtung ausgehend vom Trägerelement hin zu der ersten Hauptfläche des Halbleiterkörpers in seiner lateralen Ausdehnung verringert und beispielsweise "trichterförmig" oder nach Art eines Kegel- oder Pyramidenstumpfs ausgebildet ist.

Gemäß der erfindungsgemäßen Ausführungsform sind die Dicken des ersten Bereichs und des zweiten Bereichs in einer Richtung senkrecht zu der ersten Hauptfläche im Wesentlichen gleich groß. "Im Wesentlichen" heißt, dass sich die beiden Dicken des ersten und des zweiten Bereichs in der Richtung senkrecht zur ersten Hauptfläche um weniger als 10 %, besonders bevorzugt um weniger als 5 %, unterscheiden.

Gemäß zumindest einer Ausführungsform sind alle Seitenflächen und eine Bodenfläche des zumindest einen Grabens vollständig von der Passivierungsschicht bedeckt. Die Bodenfläche ist die der Öffnung des Grabens gegenüberliegende Fläche des zumindest einen Grabens, wobei die Bodenfläche zumindest zwei der Seitenflächen miteinander verbindet. Beispielsweise ist der zumindest eine Graben im Querschnitt "U-" oder "V"-förmig ausgebildet.

Gemäß zumindest einer Ausführungsform ist die Strahlungsauskoppelfläche im Bereich des zumindest einen Grabens und/oder dem zweiten Bereich des Halbleiterkörpers mit einer Metallisierung versehen, die auf die Passivierungsschicht aufgebracht ist. Vorzugsweise stehen die Metallisierung und die Passivierungsschicht in direktem Kontakt miteinander.

Gemäß der erfindungsgemäßen Ausführungsform erstreckt sich der zumindest eine Graben durch die Reflektorschicht hindurch.

Gemäß der erfindungsgemäßen Ausführungsform steht das Verbindungsmaterial in den von der Reflektorschicht entfernten Bereichen des Leuchtdiodenchips mit der Passivierungsschicht in direktem Kontakt. Auf die von der Reflektorschicht freiliegenden Stellen, der durch das Verbindungsmaterial ausgebildeten Bodenfläche des zumindest einen Grabens, ist die Passivierungsschicht aufgebracht.

Es wird darüber hinaus ein Verfahren zur Herstellung eines Leuchtdiodenchips angegeben. Mittels des Verfahrens kann ein Leuchtdiodenchip hergestellt werden, wie er in Verbindung mit einem oder mehreren der oben genannten erfindungsgemäßen Ausführungsformen beschrieben ist. Das heißt, die für die hier beschriebenen Leuchtdiodenchips aufgeführten Merkmale sind auch für das hier beschriebene Verfahren offenbart und umgekehrt.

In einem ersten Schritt wird ein Trägerverbund von Trägerelementen bereitgestellt. Der Trägerverbund kann beispielsweise nach Art einer Scheibe oder einer Platte ausgebildet sein. Beispielsweise ist der Trägerverbund mit Germanium oder einem anderen elektrisch leitenden Halbleitermaterial gebildet. Ferner ist denkbar, dass das Material des Trägerverbunds dotiert ist.

In einem weiteren Schritt wird ein Halbleiterverbund von Halbleiterkörpern bereitgestellt.

In einem weiteren Schritt wird der Trägerverbund und der Halbleiterverbund mittels eines Verbindungsmaterials zu einem Trägerverbund verbunden. Beispielsweise handelt es sich bei dem Verbindungsmaterial um ein elektrisch leitfähiges Lot.

In einem weiteren Schritt wird zumindest ein Graben in jeden Halbleiterkörper eingebracht, wobei im Bereich des Grabens Teile des Halbleiterkörpers entfernt werden. Der zumindest eine Graben unterteilt jeden Halbleiterkörper in einen ersten und einen zweiten Bereich.

Beispielsweise wird der zumindest eine Graben mittels mindestens eines trocken- und/oder nasschemischen Ätzprozesses oder einer anderen Form des Materialabtrags in den Halbleiterverbund eingebracht.

In einem weiteren Schritt wird der Verbund außerhalb des ersten Bereichs und des Grabens durch den Verbund in zumindest einen Leuchtdiodenchip entlang einer Trennlinie vereinzelt. Beispielsweise wird der Verbund mittels hochenergetischem Laserlichts vereinzelt. Ebenso ist es möglich, dass das Vereinzeln des Verbunds mittels Ritzen und anschließendem Brechen oder Schneidens erfolgt. Vorteilhaft wirkt während des Vereinzelns der zumindest eine Graben als Schutz gegen mechanische Beschädigungen des ersten Bereichs in jedem Halbleiterkörper. Vorteilhaft beeinträchtigen so beispielsweise durch das Vereinzeln erzeugte Materialreste nicht den Halbleiterkörper im ersten Bereich, da der Graben einen "Trennbereich" in jedem Leuchtdiodenchip definiert, der jeweils zwischen den Vereinzelungsbereichen des Verbunds und dem ersten Bereichen der Halbleiterkörper angeordnet ist. Gemäß der erfindungsgemäßen Ausführungsform wird mittels des Verfahrens ein hier beschriebener Leuchtdiodenchip hergestellt.

Im Folgenden wird der hier beschriebene Leuchtdiodenchip sowie das hier beschriebene Verfahren anhand von Ausführungsbeispielen und den dazugehörigen Figuren näher erläutert.

Die Figuren 1A, 1B, 2A, 2B, 3, 4 und 5 zeigen in schematischen Schnittdarstellungen Ausführungsbeispiele eines hier beschriebenen Leuchtdiodenchips.

Die Figuren 6 und 7 zeigen in schematischen Schnittdarstellungen einzelne Fertigungsschritte zur Herstellung eines Ausführungsbeispiels eines hier beschriebenen Leuchtdiodenchips.

Die Figur 8 zeigt in einer Draufsicht einen Verbund von Leuchtdiodenchips.

In den Ausführungsbeispielen und den Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

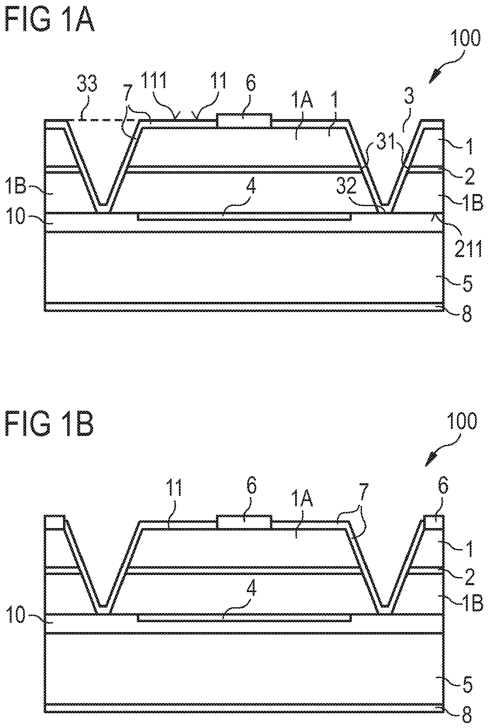

In der Figur 1 ist anhand einer schematischen Schnittdarstellung ein hier beschriebener Leuchtdiodenchip 100 mit einem Halbleiterkörper 1 gezeigt, der jedoch nicht ein Teil der Erfindung wie beansprucht darstellt. Der Halbleiterkörper 1 weist eine aktive Zone 2 auf, die im Betrieb des Leuchtdiodenchips 100 elektromagnetische Strahlung durch eine Strahlungsauskoppelfläche 11 emittiert. Die Strahlungsauskoppelfläche 11 ist im vorliegenden Ausführungsbeispiel teilweise durch eine erste Hauptfläche 111 des Halbleiterkörpers 1 gebildet. Vorzugsweise ist der Halbleiterkörper 1 mit einem nitridbasierten Verbindungshalbleitermaterial wie Galliumnitrid gebildet. In den Halbleiterkörper 1 ist ein Graben 3 eingebracht, wobei im Bereich des Grabens 3 Teile des Halbleiterkörpers entfernt sind. Der Graben 3 ist im Querschnitt "U"-förmig und durch zwei Seitenflächen 31 sowie eine einer Öffnung 32 des Grabens 3 gegenüberliegende Bodenfläche 32 gebildet. Die Bodenfläche 32 verbindet die Seitenflächen 31 miteinander. Der Graben 3 durchbricht die aktive Zone 2 vollständig, sodass der Graben 3 die aktive Zone 2 in lateraler Richtung, also beispielsweise parallel zur epitaktisch gewachsenen Halbleiterschichtenfolge des Halbleiterkörpers 1, unterteilt.

Der Graben 3 umgibt einen ersten Bereich 1A des Halbleiterkörpers 1 vollständig, wobei ebenso ein zweiter Bereich 1B des Halbleiterkörpers 1 den einen Graben 3 und den ersten Bereich 1A in lateraler Richtung vollständig umschließt. Beispielsweise umschließt der Graben den ersten Bereich rechteckförmig, kreisförmig oder oval.

Eine der ersten Hauptfläche 111 des Leuchtdiodenchips gegenüberliegende Fläche 211 des Halbleiterkörpers 1 ist mit einer Reflektorschicht 4 versehen. Vorliegend ist die Fläche 211 lediglich im ersten Bereich 1A des Halbleiterkörpers 1 mit der Reflektorschicht 4 versehen und reflektiert die von der aktiven Zone 2 innerhalb des ersten Bereichs 1A erzeugte elektromagnetische Strahlung hin zur Strahlungsauskoppelfläche 11, sodass die Reflektorschicht 4 die Auskoppeleffizienz des Leuchtdiodenchips 100 erhöht.

Ferner umfasst der Leuchtdiodenchip 100 ein Trägerelement 5 und die Reflektorschicht 4 ist zwischen dem Trägerelement und dem Halbleiterkörper 1 angeordnet. Der Halbleiterkörper 1 ist mittels eines Verbindungsmaterials 10 am Trägerelement 5 befestigt. Bei dem Verbindungsmaterial kann es sich beispielsweise um ein metallisches Lot handeln, welches den Halbleiterkörper 1 und das Trägerelement 5 mechanisch und elektrisch miteinander verbindet.

Der Leuchtdiodenchip 100 ist am ersten Bereich 1A des Halbleiterkörpers 1 mit einem elektrischen Kontakt 6 versehen. Ferner ist auf eine dem Halbleiterkörper abgewandten Fläche des Trägerelements 5 eine weitere elektrische Kontaktierung 8 aufgebracht.

Alle Seitenflächen 31, eine Bodenfläche 32 des Grabens 3 sowie alle freiliegenden Stellen der Hauptfläche 111 sind vollständig von einer Passivierungsschicht 7 bedeckt. Die Passivierungsschicht 7 verhindert eine Oxidation der freiliegenden Stellen des Halbleiterkörpers 1 und wird direkt auf alle freiliegenden Stellen der Hauptfläche 111 des Halbleiterkörpers 1 aufgebracht. "Direkt aufgebracht" heißt in diesem Zusammenhang, dass die Passivierungsschicht 7 sich vorzugsweise in direktem Kontakt mit der Hauptfläche 111 befindet und sich so weder ein Spalt noch eine Unterbrechung oder eine Zwischenschicht zwischen der Hauptfläche 111 und der Passivierungsschicht 7 ausbildet. Beispielsweise ist die Passivierungsschicht 7 mit einem der Materialien Siliziumdioxid, Siliziumnitrid, Titandioxid und/oder Siliziumdioxid gebildet. Beispielsweise ist die Passivierungsschicht 7 vollständig mit einem der genannten Materialien oder ist mit Schichten aus diesen Materialien gebildet. Ferner ist es möglich, dass auf die Hauptfläche 111 des Halbleiterkörpers 1 abwechselnd unterschiedliche Schichten aus den genannten Materialien aufgebracht sind.

Dadurch, dass sich der Graben 3 vollständig durch den Halbleiterkörper 1 hindurch erstreckt und daher die Bodenfläche 32 des Grabens 3 durch das Verbindungsmaterial 10 gebildet ist, ist das Verbindungsmaterial 10 an seiner dem Trägerelement 5 abgewandten Seite vollständig vom Halbleiterkörper 1 und der Passivierungsschicht 7 bedeckt. Mit anderen Worten ist das Verbindungsmaterial 10 lediglich im Bereich der Bodenfläche 32 des Grabens 3 nicht vom Halbleiterkörper 1 bedeckt.

Durch die "U"-förmige Ausbildung des Grabens 3 verjüngt sich der erste Bereich 1A in einer Richtung ausgehend vom Trägerelement 5 hin zur ersten Hauptfläche 111 des Halbleiterkörpers 1. Der erste Bereich 1A des Halbleiterkörpers 1 ist also seitlich durch die Seitenflächen 31 und die Strahlungsauskoppelfläche 11 begrenzt. Ferner weist auch der zweite Bereich 1B einen Teil der aktiven Zone 2 auf, ist jedoch dort nicht elektrisch kontaktiert und somit strahlungsinaktiv.

Im Unterschied zum Ausführungsbeispiel gemäß der Figur 1A zeigt das Ausführungsbeispiel der Figur 1B, der jedoch auch nicht ein Teil der Erfindung wie beansprucht darstellt, dass die Hauptfläche 111 des Halbleiterkörpers 1 zusätzlich im zweiten Bereich 1B des Halbleiterkörpers 1 mit dem elektrischen Kontakt 6 versehen ist, wird jedoch in diesem Bereich von außen nicht elektrisch kontaktiert und dient somit beispielsweise an diesen Stellen als Passivierungsschicht für den Halbleiterkörper 1.

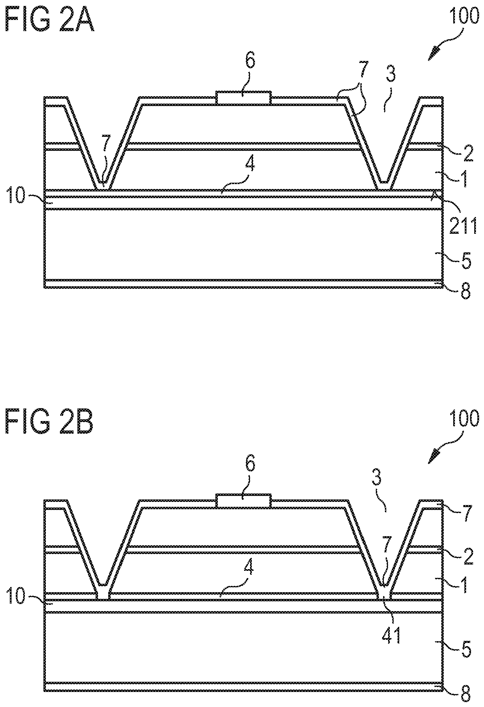

In der Figur 2A ist gezeigt, dass sich die Reflektorschicht 4 über die gesamte laterale Ausdehnung des Leuchtdiodenchips 100 erstrecken kann. Das heißt, die Fläche 211 ist sowohl im ersten Bereich 1A als auch im zweiten Bereich 1B des Halbleiterkörpers 1 mit der Reflektorschicht 4 versehen. Vorteilhaft ermöglicht die größere laterale Ausdehnung der Reflektorschicht 4 im Vergleich zu den vorher genannten Ausführungsbeispielen eine erhöhte Auskoppeleffizienz des Leuchtdiodenchips 100.

Bei dem erfindungsgemäßen Ausführungsbeispiel gemäß der Figur 2B steht das Verbindungsmaterial in den von der Reflektorschicht 4 entfernten Bereichen 41 des Leuchtdiodenchips 100 mit der Passivierungsschicht 7 in direktem Kontakt. Das heißt, dass die Reflektorschicht 4 in den Bereichen 41 entfernt ist und sich die Passivierungsschicht 7 in den Bereichen 41 einlagert. Vorzugsweise füllt die Passivierungsschicht 7 Bereiche 41 formschlüssig aus. "Formschlüssig" bedeutet hierbei, dass die Passivierungsschicht innerhalb des Bereichs 41 mit dem umgebenden Material in direktem Kontakt steht und sich beispielsweise im Bereich 41 kein Lufteinschluss ausbildet. Vorteilhaft wird so beispielsweise verhindert, dass sich Ionen der Reflektorschicht 4 im Bereich 41 aus der Reflektorschicht 4 herauslösen oder die Reflektorschicht 4 im Bereich 41 oxidiert wird.

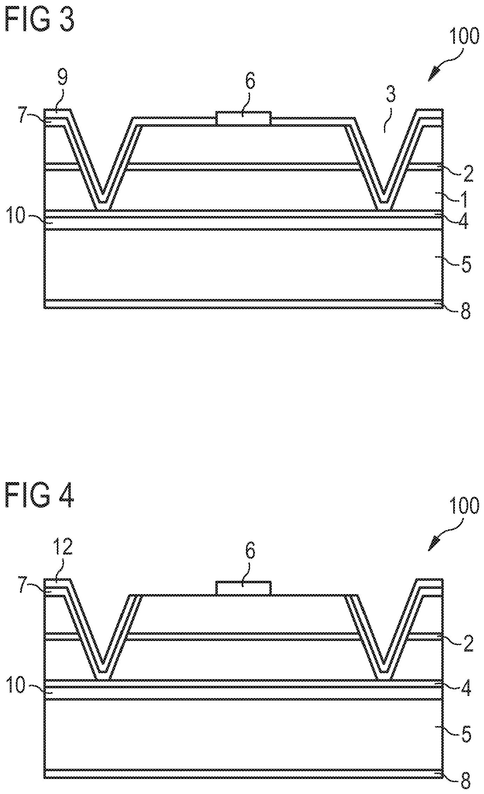

Im Unterschied zum Ausführungsbeispiel der Figur 2A ist in der Figur 3 gezeigt, dass die Passivierungsschicht 7 lediglich die Seitenflächen 31, die Bodenfläche 32 des Grabens 3 und die Hauptfläche 111 im zweiten Bereich 1B des Halbleiterkörpers 1 bedeckt. Ferner ist eine weitere Passivierungsschicht 9 auf alle von der elektrischen Kontaktierung 6 freiliegenden Stellen der ersten Hauptfläche 111 aufgebracht. Beispielsweise ist die weitere Passivierungsschicht 9 mit Siliziumdioxid gebildet.

In der Figur 4 ist abweichend von dem Leuchtdiodenchip 100 der Figur 3 gezeigt, dass statt der weiteren Passivierungsschicht 9 auf die Passivierungsschicht 7 eine Metallisierung 12 aufgebracht ist. Die erste Hauptfläche 111 ist also im Bereich des Grabens 3 und dem zweiten Bereich 1B des Halbleiterkörpers 1 mit der Metallisierung 12 versehen, die auf die Passivierungsschicht 7 aufgebracht ist. Beispielsweise ist die Strahlungsauskoppelfläche 11 im ersten Bereich 1A dann frei von jeder Schicht. Vorteilhaft wird während eines Vereinzelns in einzelne Leuchtdiodenchips 100, beispielsweise mittels hochenergetischen Laserlichts, die elektromagnetische Strahlung durch die Metallisierung 12 absorbiert, wodurch der Trennvorgang von der Metallisierung 12 aus eingeleitet wird. Die Metallisierung 12 verringert beispielsweise "Abplatzer" des Halbleitermaterials im zweiten Bereich 1B des Halbleiterkörpers 1.

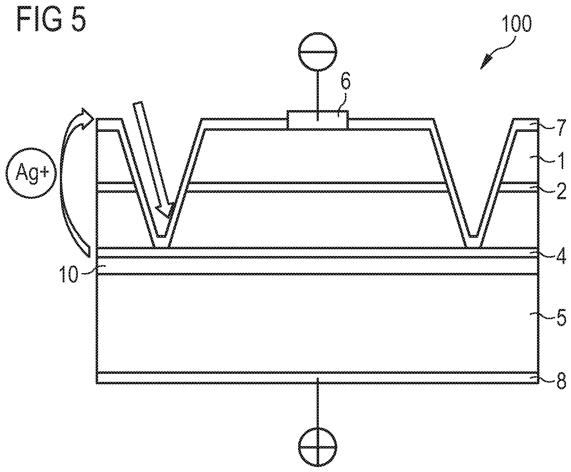

Die Figur 5 zeigt den Leuchtdiodenchip 100 der Figur 2A, bei dem der elektrische Kontakt 6 den n-seitigen Kontakt und die weitere elektrische Kontaktierung 8 den p-seitigen Kontakt des Leuchtdiodenchips 100 bildet. Ist der Leuchtdiodenchip 100 von einem Regime mit hoher Luftfeuchtigkeit umgeben, so ist es möglich, dass durch die Feuchtigkeit Silberionen der Reflektorschicht 4 herausgelöst werden und entlang von Außenflächen des Leuchtdiodenchips 100 in Richtung des elektrischen Kontaktes 6 wandern (auch Ionen-Migration). Vorteilhaft verhindert der Graben 3 einen Kurzschluss zwischen dem elektrischen Kontakt 6 und den Silberionen, da die Silberionen innerhalb des Grabens 3 gegen das sich im Graben 3 befindliche elektrische Feld anlaufen müssten. Das elektrische Feld im Graben 3 bildet daher eine Potentialbarriere für die positiv geladenen Silberionen. Ein Kurzschluss zwischen den Silberionen und dem elektrischen Kontakt 6 wird so verhindert, wodurch sich nicht nur die Lebensdauer des Leuchtdiodenchips erheblich erhöht, sondern ebenso beispielsweise dessen Zuverlässigkeit im Betrieb.

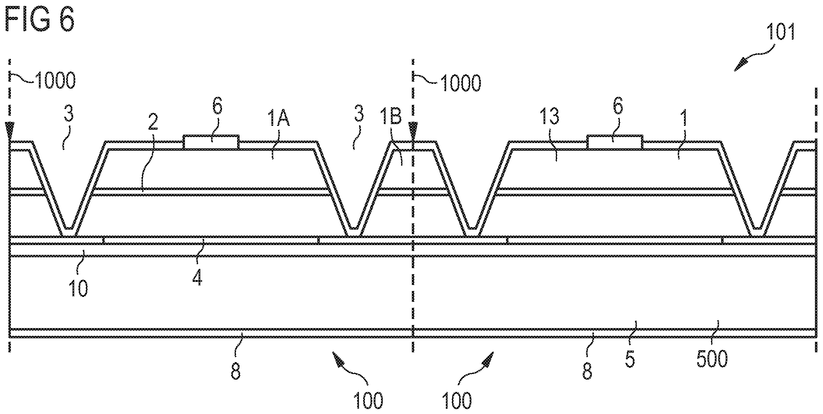

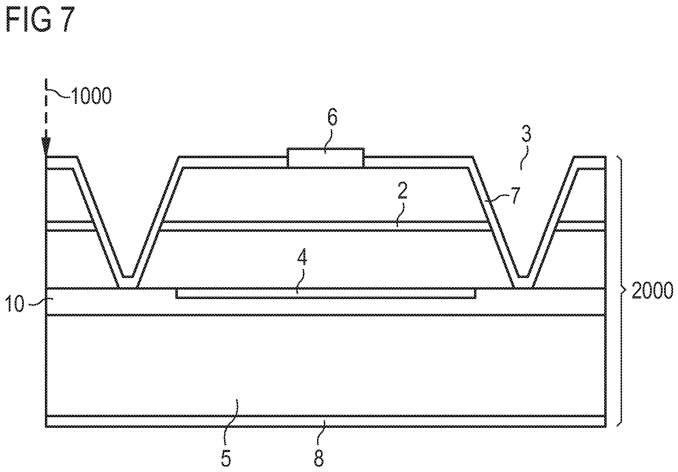

In Verbindung mit den Figuren 6 und 7 wird anhand schematischer Schnittdarstellung ein hier beschriebenes Verfahren zur Herstellung eines Leuchtdiodenchips 100 gemäß zumindest einer Ausführungsform näher erläutert.

Die Figur 6 zeigt einen Trägerverbund 500 von Trägerelementen 5. Der Trägerverbund 500 kann mit einem Halbleitermaterial, wie beispielsweise Germanium, gebildet sein. Beispielsweise liegt der Trägerverbund 500 in Form von Scheiben oder Platten vor.

In einem nächsten Schritt wird ein Halbleiterverbund 13 von Halbleiterkörpern 1 bereitgestellt. Der Halbleiterverbund 13 kann mit einer epitaktisch gewachsenen Halbleiterschichtenfolge gebildet sein, der eine aktive Zone 2 zur Emission von elektromagnetischer Strahlung umfasst. Vorzugsweise ist der Halbleiterverbund 13 mit einem nitridbasierten Verbindungsmaterial, beispielsweise Galliumnitrid, gebildet.

In einem nächsten Schritt wird der Trägerverbund 500 und der Halbleiterverbund 13 mittels eines Verbindungsmaterials 5 verbunden. Beispielsweise wird dazu auf eine Außenfläche des Trägerverbunds 500 das Verbindungsmaterial 5 aufgebracht. Bei einem Verbindungsmaterial 5 kann es sich um ein elektrisch leitfähiges Lot handeln. Der Trägerverbund 500 und der Halbleiterverbund 13 bilden dann zusammen einen Verbund 101.

In einem weiteren Schritt wird ein Graben 3 in jeden Halbleiterkörper 1 eingebracht, wobei im Bereich des Grabens 3 Teile des Halbleiterkörpers entfernt werden und der Graben 3 den Halbleiterkörper 1 in einen ersten Bereich 1A und einen zweiten Bereich 1B unterteilt. Beispielsweise ist der Graben 3 mittels mindestens eines trocken- und/oder nasschemischen Ätzprozesses in jeden Halbleiterkörper 1 eingebracht.

Jeder Halbleiterkörper 1 ist im ersten Bereich 1A mit einem elektrischen Kontakt 6 versehen, wobei gleichzeitig alle von dem elektrischen Kontakt 6 freiliegenden Stellen der von dem Trägerverbund 500 abgewandten Fläche des Halbleiterverbunds 13 mit einer Passivierungsschicht 7 versehen sind. Weiter ist eine dem Halbleiterverbund 13 gegenüberliegende Fläche des Trägerverbunds 500 mit einer elektrischen Kontaktierung 8 versehen.

In dem Verfahren ist es vorgesehen, dass vor dem Aufbringen des Halbleiterverbunds 13 auf das Verbindungsmaterial eine Reflektorschicht 4 als eine durchgehende Schicht über die gesamte laterale Erstreckung des Trägers 500 aufgebracht wird. Die Reflektorschicht 4 kann beispielsweise mit einem metallischen Material, insbesondere einem Silber, gebildet sein.
In einem nächsten Schritt wird der Verbund 101 außerhalb des ersten Bereichs 1A und des Grabens 3 durch den Verbund 101 in eine Vielzahl von Leuchtdiodenchips 100 entlang einer Trennlinie 1000 vereinzelt. Das Vereinzeln kann beispielsweise mittels hochenergetischen Laserlichts geschehen. Ebenso ist es möglich, dass das Vereinzeln mittels Ritzen und anschließendem Brechen oder Schneidens erfolgt.

Durch Verwendung von Galliumnitrid als Halbleitermaterial für den Halbleiterverbund 13 ergibt sich insbesondere bei der Vereinzelung mittels hochenergetischem Laserlichts eine gute Trennqualität durch das Halbleitermaterial. Das heißt, dass der durch das Laserlicht erzeugte Materialabtrag möglichst gering ist.

Ferner dient der Graben 3 als Schutz gegen mechanische Beschädigungen, die beim Trennen oder bei der Weiterverarbeitung der einzelnen Leuchtdiodenchips 100 auftreten können. Ferner wird durch die Schutzfunktion des Grabens 3 während des Vereinzelns die Passivierungsschicht 7 im Bereich 1A nicht beschädigt.

Ebenso werden durch den Graben 3 bei der Vereinzelung außerhalb des Grabens 3 und des ersten Bereichs 1A erzeugte Abplatzer der Passivierungsschicht 7 vermieden, wodurch die Passivierungsschicht 7 im Bereich 1A unbeschädigt bleibt.

Die Figur 7 zeigt einen solchen vereinzelten Leuchtdiodenchip 100, der mittels Vereinzelung des Verbunds 101 außerhalb des Grabens 3 und des ersten Bereichs 1 erzeugt ist. Der Leuchtdiodenchip 100 zeigt lediglich im Bereich 2000 Vereinzelungsspuren, die ausschließlich auf den zweiten Bereich 1B des Halbleiterkörpers 1 beschränkt sind, wodurch der Bereich 1A des Halbleiterkörpers 1 keinerlei Beschädigungen durch das Vereinzeln aufweist.

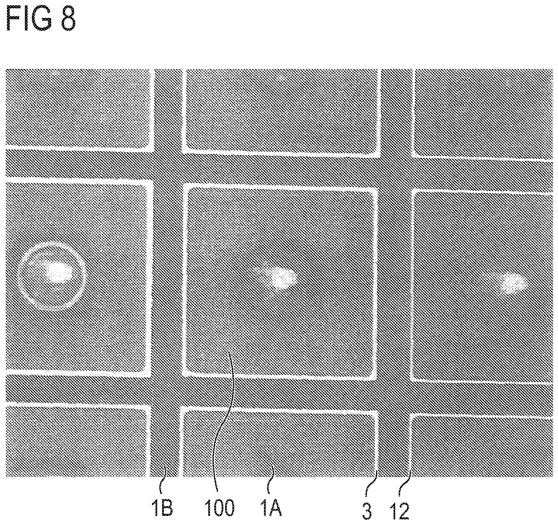

Die Figur 8 zeigt einen solchen Verbund 101 in einer Draufsicht. Erkennbar sind sowohl die ersten Bereiche 1A als auch die zweiten Bereiche 1B jedes Leuchtdiodenchips 100. Der erste Bereich 1A ist jeweils von dem Graben 3 rechteckförmig vollständig umschlossen, wobei der Graben 3 gleichzeitig mit der Metallisierung 12 versehen ist.

Die hier beschriebene Erfindung ist nicht durch die Beschreibung anhand der Ausführungsbeispiele beschränkt. Vielmehr umfasst die Erfindung jede Kombination von Merkmalen wie in den Patentansprüchen beinhaltet.

## Patentansprüche

1. Leuchtdiodenchip (100), umfassend:
- einen Halbleiterkörper (1), der einen ersten (1A) und einen zweiten Bereich (1B) aufweist;
- eine aktive Zone (2) innerhalb des Halbleiterkörpers (1), die im Betrieb des Leuchtdiodenchips (100) elektromagnetische Strahlung durch eine Strahlungsauskoppelfläche (11) emittiert, die zumindest stellenweise durch eine erste Hauptfläche (111) des Halbleiterkörpers (1) gebildet ist, wobei
- eine der ersten Hauptfläche (111) des Leuchtdiodenchips (100) gegenüberliegende Fläche des Halbleiterkörpers (1) mit einer Reflektorschicht (4) versehen ist,
- der Leuchtdiodenchip (100) ein Trägerelement (5) umfasst und die Reflektorschicht (4) zwischen dem Trägerelement (5) und dem Halbleiterkörper (1) angeordnet ist, wobei der Halbleiterkörper (1) mittels eines Verbindungsmaterials (10) am Trägerelement (5) befestigt ist,
- zumindest einen Graben (3) in dem Halbleiterkörper (1), wobei im Bereich des Grabens Teile des Halbleiterkörpers (1) entfernt sind, wobei
- der zumindest eine Graben (3) zumindest bis zur aktiven Zone (2) reicht,
- der zumindest eine Graben (3) den ersten Bereich (1A) in lateraler Richtung vollständig umgibt, und
- der zweite Bereich (1B) den zumindest einen Graben (3) und den ersten Bereich (1A) in lateraler Richtung vollständig umgibt,
**dadurch gekennzeichnet dass**:
- der zumindest eine Graben (3) sich durch die Reflektorschicht (4) hindurch erstreckt, und
- alle Seitenflächen (31) und eine Bodenfläche (32) des zumindest einen Grabens (3) vollständig von einer Passivierungsschicht (7) bedeckt sind,
- das Verbindungsmaterial (10) in den von der Reflektorschicht (4) entfernten Bereichen (41) des Leuchtdiodenchips (100) mit der Passivierungsschicht (7) in direktem Kontakt steht.

2. Leuchtdiodenchip (100) gemäß dem vorhergehenden Anspruch,
bei dem das Verbindungsmaterial (10) an seiner dem Trägerelement (5) abgewandten Seite vollständig vom Halbleiterkörper (1) und/oder der Passivierungsschicht (7) bedeckt ist.

3. Leuchtdiodenchip (100) gemäß dem vorhergehenden Anspruch,
bei dem das Verbindungsmaterial (10) lediglich im Bereich des zumindest einen Grabens (3) nicht von dem Halbleiterkörper (1) bedeckt ist.

4. Leuchtdiodenchip (100) gemäß einem der vorhergehenden Ansprüche,
bei dem sich der erste Bereich (1A) des Halbleiterkörpers (1) in einer Richtung ausgehend vom Trägerelement (5) hin zur ersten Hauptfläche (111) des Halbleiterkörpers (1) verjüngt.

5. Leuchtdiodenchip (100) gemäß einem der vorhergehenden Ansprüche,
bei dem die Dicken des ersten Bereichs (1A) und des zweiten Bereichs (1B) in einer Richtung senkrecht zur ersten Hauptfläche (111) im Wesentlichen gleich groß sind.

6. Leuchtdiodenchip (100) gemäß einem der vorhergehenden Ansprüche,
bei dem die Strahlungsauskoppelfläche (11) im Bereich des zumindest einen Grabens (3) und/oder dem zweiten Bereich (1B) des Halbleiterkörpers (1) mit einer Metallisierung (12) versehen ist, die auf die Passivierungsschicht (7) aufgebracht ist.

7. Leuchtdiodenchip (100) gemäß einem der vorhergehenden Ansprüche, bei dem das Verbindungsmaterial (10) mit einem Klebstoff gebildet ist.

8. Leuchtdiodenchip (100) gemäß einem der vorhergehenden Ansprüche, bei dem die Reflektorschicht (4) aus einem metallischen Material gebildet ist.

9. Leuchtdiodenchip (100) gemäß einem der vorhergehenden Ansprüche, bei dem die Reflektorschicht (4) aus Silber gebildet ist.

10. Verfahren zur Herstellung eines Leuchtdiodenchips (100) gemäß einem der Ansprüche 1 bis 9 mit den folgenden Schritten:
- Bereitstellen eines Trägerverbunds (500) von Trägerelementen (5);
- Bereitstellen eines Halbleiterverbunds (13) von Halbleiterkörpern (1);
- Verbinden des Trägerverbunds (500) und des Halbleiterverbunds (13) mittels eines Verbindungsmaterials (5) zu einem Verbund (101);
- Einbringen von zumindest einem Graben (3) in jeden Halbleiterkörper (1), wobei im Bereich des Grabens (3) Teile des Halbleiterkörpers (1) entfernt werden und der Graben (3) den Halbleiterkörper (1) in einen ersten (1A) und einen zweiten Bereich (1B) unterteilt;
- Vollständig Bedecken aller Seitenflächen (31) und der Bodenfläche des zumindest eines Grabens (3) mit einer Passivierungsschicht(7), wobei die Passivierungsschicht (7) mit der Reflektorschicht (4) und dem Verbindungsmaterial (10) in direktem Kontakt steht;
- Vereinzeln des Verbunds (101) aus Trägerverbund (500) und Halbleiterverbund (13) außerhalb des ersten Bereichs (1A) und des Grabens (3) durch den Verbund (101) in zumindest einen Leuchtdiodenchip (100) entlang einer Trennlinie (1000).

## Claims

1. Light-emitting diode chip (100), comprising:
- a semiconductor body (1) having a first (1A) and a second region (1B);
- an active zone (2) within the semiconductor body (1), which active zone, during the operation of the light-emitting diode chip (100), emits electromagnetic radiation through a radiation coupling-out area (11) formed at least in places by a first main area (111) of the semiconductor body (1), wherein
- an area of the semiconductor body (1) which lies opposite the first main area (111) of the light-emitting diode chip (100) is provided with a reflector layer (4),
- the light-emitting diode chip (100) comprises a carrier element (5) and the reflector layer (4) is arranged between the carrier element (5) and the semiconductor body (1), wherein the semiconductor body (1) is fixed to the carrier element (5) by means of a connecting material (10),
- at least one trench (3) in the semiconductor body (1) wherein parts of the semiconductor body (1) are removed in the region of the trench, wherein
- the at least one trench (3) extends at least as far as the active zone (2),
- the at least one trench (3) completely surrounds the first region (1A) in a lateral direction, and
- the second region (1B) completely surrounds the at least one trench (3) and the first region (1A) in a lateral direction,
**characterized in that**:
- the at least one trench (3) extends through the reflector layer (4), and
- all side areas (31) and a base area (32) of the at least one trench (3) are covered completely by a passivation layer (7),
- the connecting material (10) is in direct contact with the passivation layer (7) in the regions (41) of the light-emitting diode chip (100) which have been removed from the reflector layer (4).

2. Light-emitting diode chip (100) according to the preceding claim,
wherein the connecting material (10), at its side remote from the carrier element (5) is covered completely by the semiconductor body (1) and/or the passivation layer (7).

3. Light-emitting diode chip (100) according to the preceding claim,
wherein the connecting material (10) is not covered by the semiconductor body (1) only in the region of the at least one trench (3).

4. Light-emitting diode chip (100) according to any of the preceding claims,
wherein the first region (1A) of the semiconductor body (1) tapers in a direction proceeding from the carrier element (5) towards the first main area (111) of the semiconductor body (1).

5. Light-emitting diode chip (100) according to any of the preceding claims,
wherein the thicknesses of the first region (1A) and of the second region (1B) in a direction perpendicular to the first main area (111) are substantially identical in magnitude.

6. Light-emitting diode chip (100) according to any of the preceding claims,
wherein the radiation coupling-out area (11), in the region of the at least one trench (3) and/or the second region (1B) of the semiconductor body (1), is provided with a metallization (12) applied to the passivation layer (7).

7. Light-emitting diode chip (100) according to any of the preceding claims, wherein the connecting material (10) is formed with an adhesive.

8. Light-emitting diode chip (100) according to any of the preceding claims, wherein the connecting material (10) is formed from a metallic material.

9. Light-emitting diode chip (100) according to any of the preceding claims, wherein the reflector layer (4) is formed from silver.

10. Method for producing a light-emitting diode chip (100) according to any of Claims 1 to 9, comprising the following steps:
- providing a carrier assemblage (500) of carrier elements (5);
- providing a semiconductor assemblage (13) of semiconductor bodies (1);
- connecting the carrier assemblage (500) and the semiconductor assemblage (13) by means of a connecting material (5) to form an assemblage (101) ;
- introducing at least one trench (3) into each semiconductor body (1), wherein parts of the semiconductor body (1) are removed in the region of the trench (3) and the trench (3) subdivides the semiconductor body (1) into a first (1A) and a second region (1B) ;
- completely covering all side areas (31) and the base area of the at least one trench (3) with a passivation layer (7), wherein the passivation layer (7) is in direct contact with the reflector layer (4) and the connecting material (10) ;
- singulating the assemblage (101) composed of carrier assemblage (500) and semiconductor assemblage (13) outside the first region (1A) and the trench (3) through the assemblage (101) into at least one light-emitting diode chip (100) along a separating line (1000).

## Revendications

1. Puce de diode électroluminescente (100), comprenant:
- un corps en semiconducteur (1) qui possède une première (1A) et une deuxième zone (1B);
- une zone active (2) à l'intérieur du corps en semiconducteur (1) qui, lors du fonctionnement de la puce de diode électroluminescente (100), émet un rayonnement à travers une surface de sortie de rayonnement (11) qui est formée au moins en certains endroits par une première surface principale (111) du corps en semiconducteur (1),
- une surface du corps en semiconducteur (1) qui se trouve à l'opposé de la première surface principale (111) de la puce de diode électroluminescente (100) étant munie d'une couche réfléchissante (4),
- la puce de diode électroluminescente (100) comprenant un élément porteur (5) et la couche réfléchissante (4) étant disposée entre l'élément porteur (5) et le corps en semiconducteur (1), le corps en semiconducteur (1) étant fixé à l'élément porteur (5) au moyen d'un matériau de liaison (10),
- au moins une tranchée (3) dans le corps en semiconducteur (1), des parties du corps en semiconducteur (1) étant retirées dans la zone de la tranchée,
- l'au moins une tranchée (3) se poursuivant au moins jusqu'à la zone active (2),
- l'au moins une tranchée (3) entourant entièrement la première zone (1A) dans la direction latérale et
- la deuxième zone (1B) entourant entièrement l'au moins une tranchée (3) et la première zone (1A) dans la direction latérale,
**caractérisée en ce que**
- l'au moins une tranchée (3) s'étend à travers la couche de réflexion (4), et
- toutes les surfaces latérales (31) et une surface de fond (32) de l'au moins une tranchée (3) sont entièrement recouvertes par une couche de passivation (7),
- le matériau de liaison (10) se trouve en contact direct avec la couche de passivation (7) dans les zones (41) de la puce de diode électroluminescente (100) qui sont éloignées de la couche réfléchissante (4).

2. Puce de diode électroluminescente (100) selon la revendication précédente, avec laquelle le matériau de liaison (10) est entièrement recouvert par le corps en semiconducteur (1) et/ou la couche de passivation (7) sur son côté à l'opposé de l'élément porteur (5).

3. Puce de diode électroluminescente (100) selon la revendication précédente, avec laquelle le matériau de liaison (10) n'est pas recouvert par le corps en semiconducteur (1) uniquement dans la zone de l'au moins une tranchée (3).

4. Puce de diode électroluminescente (100) selon l'une des revendications précédentes, avec laquelle la première zone (1A) du corps en semiconducteur (1) se rétrécit dans une direction partant de l'élément porteur (5) vers la première surface principale (111) du corps en semiconducteur (1).

5. Puce de diode électroluminescente (100) selon l'une des revendications précédentes, avec laquelle l'épaisseur de la première zone (1A) et de la deuxième zone (1B) dans une direction perpendiculaire à la première surface principale (111) sont sensiblement identiques.

6. Puce de diode électroluminescente (100) selon l'une des revendications précédentes, avec laquelle la surface de sortie de rayonnement (11), dans la zone de l'au moins une tranchée (3) et/ou de la deuxième zone (1B) du corps en semiconducteur (1), est dotée d'une métallisation (12) qui est appliquée sur la couche de passivation (7).

7. Puce de diode électroluminescente (100) selon l'une des revendications précédentes, avec laquelle le matériau de liaison (10) est formé par une substance adhésive.

8. Puce de diode électroluminescente (100) selon l'une des revendications précédentes, avec laquelle la couche réfléchissante (4) est constituée d'un matériau métallique.

9. Puce de diode électroluminescente (100) selon l'une des revendications précédentes, avec laquelle la couche réfléchissante (4) est constituée d'argent.

10. Procédé de fabrication d'une puce de diode électroluminescente (100) selon l'une des revendications 1 à 9, comprenant les étapes suivantes :
- fourniture d'un composé porteur (500) d'éléments porteurs (5);
- fourniture d'un composé semiconducteur (13) de corps en semiconducteur (1);
- assemblage du composé porteur (500) et du composé semiconducteur (13) au moyen d'un matériau de liaison (5) en un composé (101) ;
- mise en place d'au moins une tranchée (3) dans chaque corps en semiconducteur (1), des parties du corps en semiconducteur (1) étant retirées dans la zone de la tranchée (3) et la tranchée (3) divisant le corps en semiconducteur (1) en une première (1A) et une deuxième zone (1B) ;
- recouvrement intégral de toutes les surfaces latérales (31) et de la surface de fond de l'au moins une tranchée (3) avec une couche de passivation (7), la couche de passivation (7) se trouvant en contact direct avec la couche réfléchissante (4) et le matériau de liaison (10);
- isolation du composé (101) constitué du composé porteur (500) et du composé semiconducteur (13) en-dehors de la première zone (1A) et de la tranchée (3) à travers le composé (101) en au moins une puce de diode électroluminescente (100) le long d'une ligne de séparation (1000).
